Europäisches Patentamt

European Patent Office

Office européen des brevets

(11) Publication number: **0 314 372**
**A2**

# EUROPEAN PATENT APPLICATION

(21) Application number: **88309770.1**

(22) Date of filing: **19.10.88**

(51) Int. Cl.⁴: **H01S 3/19**

(30) Priority: **29.10.87 US 114910**

(43) Date of publication of application:
**03.05.89 Bulletin 89/18**

(84) Designated Contracting States:
**DE FR GB NL SE**

(71) Applicant: **AMERICAN TELEPHONE AND TELEGRAPH COMPANY**
**550 Madison Avenue**
**New York, NY 10022(US)**

(72) Inventor: **Koren, Uziel**
**26 Forrest Avenue**
**Fair Haven New Jersey 07701(US)**

(74) Representative: **Watts, Christopher Malcolm Kelway et al**
**AT&T (UK) LTD. AT&T Intellectual Property Division 5 Mornington Road**
**Woodford Green Essex IG8 OTU(GB)**

(54) **Current confinement and blocking region for semiconductor devices.**

(57) Improved current confinement and current blocking are achieved in a semiconductor device including a doped (n or p type) semiconductor layer (32) within a region of high resistivity semiconductor material (31,33). In another embodiment, a plurality of doped semiconductor layers are interleaved with a plurality of high resistivity semiconductor layers.

FIG.4

## CURRENT CONFINEMENT AND BLOCKING REGION FOR SEMICONDUCTOR DEVICES

Technical Field

This invention relates to semiconductor devices, and more particularly, to current blocking regions therein.

Background of the Invention

Semiconductor devices, whether optical or electronic or opto-electronic, usually include electronically active regions and electronically passive regions. One type of electronically passive regions consists of those regions which inhibit or block current flow or substantially constrain or confine current flow to an adjacent electronically active region.

In semiconductor lasers and various electronic devices such as FETs and the like, large regions of semi-insulating semiconductor material have been formed about active regions to act as current confinement or current blocking regions. See, for example, U. Koren et al., Electronics Letters, Vol. 20, No. 4, p. 177 et seq. (1984); N. K. Dutta et al., Appl. Phys. Lett., 48 (23), p. 1572 et seq. (1986); and S. M. Sze, Semiconductor Devices: Physics and Technology, pp. 181-6 (Wiley: 1985). A widely-used alternative to employing semi-conductor material for current confinement has been the use of reverse-biased p-n junction (also called blocking junctions) formed in regions adjacent to the active region. See, for example, M. A. Pollack, Proceedings of National Electronics Conf., Vol. 38, pp. 138-141 (1984).

While these approaches are suitable for blocking and confining current in theory, they allow the presence of a sufficient number of current leakage paths in practice to require improvement. It should be understood that the presence of current leakage paths is detrimental to device operation because it permits current to bypass the electronically active region of the device. In a semiconductor laser, for example, current leakage paths lead to high lasing threshold, low differential quantum efficiency, abnormal temperature dependence of threshold current, rollover of the light-current (L-I) characteristic, and reduced modulation bandwidth among other disadvantages.

Summary of the Invention

Current confinement and current blocking in a semiconductor device are improved by employing a region including successive layers of high resistivity semiconductor material, doped semiconductor material and substantially undoped semiconductor material. In another embodiment, a plurality of successive layers, wherein one layer is high resistivity semiconductor material and another layer is doped semiconductor material, is employed for current confinement and blocking.

Brief Description of the Drawing

A more complete understanding of the invention may be obtained by reading the following description of a specific illustrative embodiment of the invention in conjunction with the appended drawing in which:

FIGS. 1 through 4 depict end views of a buried heterostructure laser embodying the invention at different steps in the fabrication procedure; and

FIGS. 5 and 6 show end views of different buried heterostructure lasers embodying the invention.

Detailed Description

The present invention is applicable to many types of photonic, electronic and optoelectronic devices. However, for ease of presentation and understanding, the following description of the invention is presented in terms of a semiconductor laser embodiment in the InP/InGaAsP system.

Present optical communication systems require reasonably high output powers and modulation bandwidths for their optical sources. Recent semiconductor lasers, for example, have exhibited reasonably high output powers while faring only modestly with respect to modulation bandwidth. While the system requirements are different, they are not contradictory. That is, it is not necessary that output power be traded off against modulation bandwidth. Both high output power and high modulation bandwidth are theoretically achievable when a high photon density is created in the active region of the device.

It has been demonstrated that high power operation in semiconductor lasers may be achieved by preventing or inhibiting lateral leakage currents occurring at high operating temperatures and under high drive current conditions. As described above, reversed biased pn junctions (blocking junctions) and regrown semi-insulating regions adjacent to the buried heterostructure have been employed separately to reduce the lateral leakage currents by lowering parasitic capacitance.

When semi-insulating materials have been employed, parasitic capacitance remains in close proximity to the buried heterostructure. It is now understood that this occurs from diffusion of the dopant materials out from the heterostructure into the semi-insulating region adjacent thereto. The depth to which this out diffusion occurs is not accurately controllable. This results in significant doping of the semi-insulating region to a particular type conductivity thereby creating current leakage paths around the buried heterostructure. For example, when a p-type buried heterostructure is grown over an n-type substrate, the outdiffusion of p-type dopants such as zinc and the like cause the adjacent semi-insulating region to become p-type near the buried heterostructure. In turn, the affected semi-insulating region forms a forward biased pn junction with the substrate which permits leakage currents to flow there through.

Other problems arise during operation of such devices. For example, the presence of deep acceptor traps from dopant atoms such as iron in the semi-insulating region of InP, for example, allows hole injection from the adjacent p-type region into the semi-insulating region under applied current conditions. This type of leakage current is also undesirable and detracts from optimum device performance characteristics.

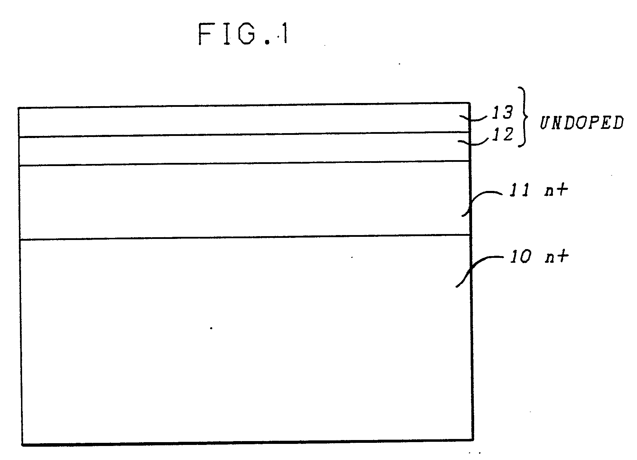

FIGs. 1 through 4 depict stages in fabrication of an exemplary laser embodying the principles of the invention. For the first step in the fabrication process shown in FIG. 1, a heavily doped (n+) layer 11 of InP is grown epitaxially on a similarly doped substrate layer 10 of InP. N-type dopants such as sulfur or selenium or the like are employed to achieve a carrier concentration in the doped layers in excess of $10^{18} cm^{-3}$. Active layer 12 is then grown over layer 11 to a thickness of approximately 0.2 $\mu m$. The active layer is undoped quaternary semiconductor material such as InGaAsP and, in an example from experimental practice, exhibits a luminescence peak at approximately 1.3 $\mu m$. Undoped waveguide layer 13 is grown over the active layer 12 to a thickness of approximately 0.15 $\mu m$. The waveguide layer 13 in experimental practice has exhibited an exemplary luminescence peak at a wavelength of approximately 1.1 $\mu m$. In some cases, layer 13 may be slightly p-doped.

The wafer shown in FIG. 1 can be grown by any standard planar epitaxial growth technique such as liquid phase epitaxy, molecular beam epitaxy, metal organic chemical vapor deposition, or vapor phase epitaxy. Each growth technique produces wafers of different crystal quality and compositional uniformity. For the example described above, liquid phase epitaxial growth has been employed to produce the heterostructure wafer.

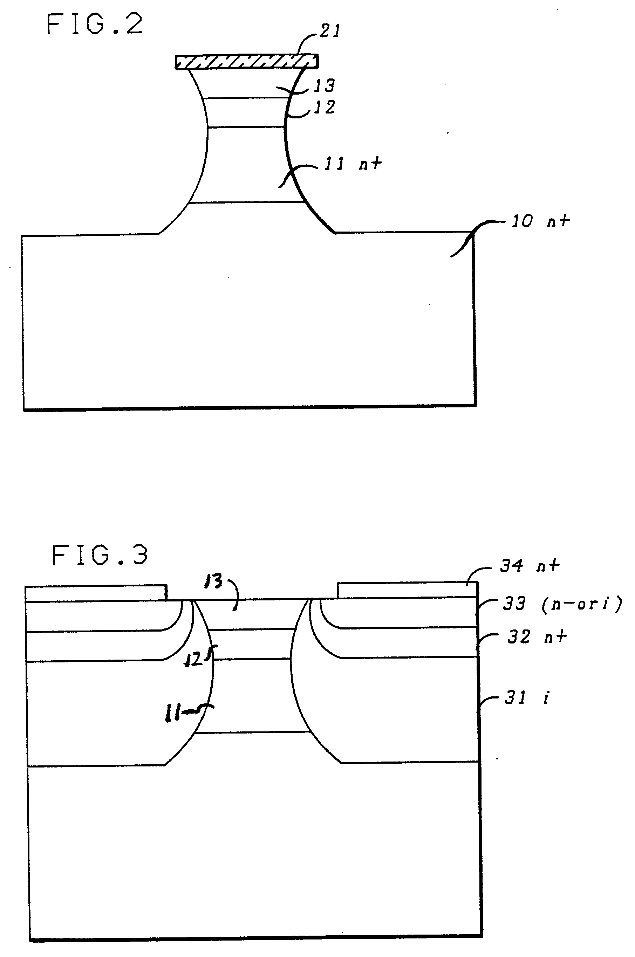

The heterostructure shown in FIG. 1 is patterned with a standard photolithographic masking and etching process to create a mesa structure. Silicon dioxide ($SiO_2$) mask 21 shown in FIG. 2 is applied over the mesa region. A chemical etchant is then applied to the semiconductor wafer to remove unwanted semiconductor material and produce an exposed mesa as shown in the FIG. 2. In one example, an etchant such as KKI (a mixture of $HCl:CH_3COOH:H_2O_2$ in the ratio 1:1:1 at 4° C) is employed to form the mesa shown wherein the mesa has a height of approximately 2.5 $\mu m$ and a width of approximately 1.5 $\mu m$.

In order to produce the planar structure in FIG. 3, it is necessary to epitaxially regrow the blocking region adjacent to and in contact with the heterostructure mesa. The purpose of the blocking region is to force an applied current flow to be substantially through the heterostructure mesa.

During regrowth of the blocking region, mask 21 is left atop the heterostructure mesa. High resistivity semiconductor layer 31 is grown on an exposed surface of substrate 10. Layer 31 is overgrown by a heavily doped (n+) semiconductor layer 32 followed by a high resistivity semiconductor layer 33.

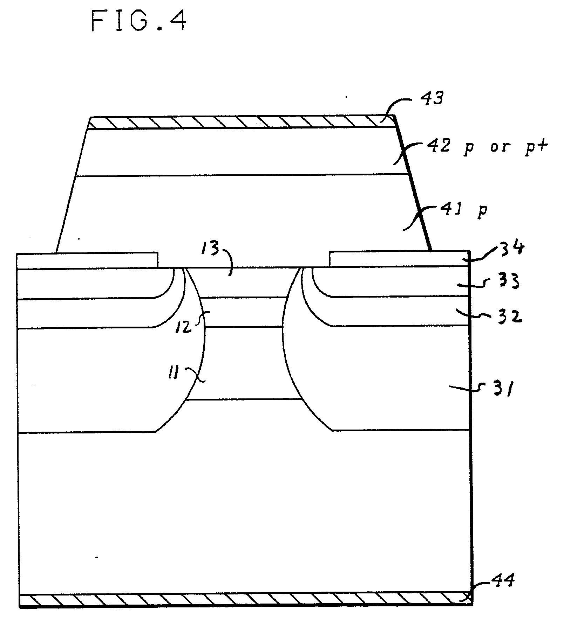

Since the entire structure is to be overgrown with contact and cap layers (shown in FIG. 4), it is advantageous to overgrow layer 33 with heavily doped semiconductor buffer layer 34. Buffer layer 34 prevents diffusion of p-type dopants into the high resistivity layers and serves as a barrier to hole injection currents during operation.

In the example from experimental practice, metal organic chemical vapor deposition was utilized to grow the epitaxial layers in the blocking region. High resistivity layers 31 and 33 are comprised of Fe:InP with respective thickness ranges of 1.0 to 2.0 $\mu m$ and 0.25 to 0.75 $\mu m$. Layer 32 is n+ doped (sulfur at $10^{+18} cm^{-3}$) InP with a thickness of 0.25 to 0.75 $\mu m$. Layer 34 is comprised of n+ doped InP with a thickness of 0.1 to 0.5 $\mu m$.

High resistivity as the term is used herein is intended to mean a resistivity in excess of $10^3 \Omega$-cm. As understood by those skilled in the art, semi-insulating materials such as Fe:InP and Ti:InP and intrinsic or insignificantly doped semiconductor materials can be substituted in the high resistivity layers while achieving the desired benefits of the invention. In practice, however, the best results have occurred for semi-insulating semiconductor material in the high resistivity layers, for layer 31 being approximately twice the thickness of layer 32, and for layers 32, 33 and 34 having approximately equal thicknesses. For example, layers 32, 33 and 34 are approximately 0.5 $\mu m$ thick while

layer 31 is approximately 1.0 $\mu m$ thick.

Following regrowth of the blocking region, mask 21 is removed with buffered HE. Oxide and containment layers are removed by a shallow (≈50 *Angstroms*) etching procedure with a standard non-selective etchant such as bromine methanol.

FIG. 4 shows the completed laser structure. Cladding layer 41 is a p-doped (zinc dopant at a concentration between $10^{17}$ *and* $10^{18}$ $cm^{-3}$) InP semiconductor layer for the exemplary embodiment. Layer 41 is epitaxially grown to a thickness of 1.0 to 2.5 $\mu m$. Contact layer 42 is doped similarly to layer 41. In the exemplary embodiment, contact layer 42 is comprised of p-doped or $p+$-doped InGaAs epitaxially grown over layer 41 to a thickness of 0.25 to 1.0 $\mu m$. Channels are etched with 20 to 40 $\mu m$ spacing to create a contact mesa and, thereby, reduce parasitic capacitance. Electrical contacts 43 and 44 are then electroplated as shown to complete laser fabrication. Standard metallic contacts are employed such as multiplayer alloyed gold and zinc over a gold layer.

With respect to laser device technology, the present structure has the benefit of presenting a substantially planar structure after each of the major epitaxial growth sequences. Planarity is important to reduction of strain on the active layer thereby tending to improve device yield and reliability. In experimental practice, the laser device shown in FIG. 4 has been operated at a high modulation bandwidth of more than 12 GHz for small signals and a high output power of approximately 20 mW CW at a drive current of 100 mA. Both results are directly attributable to the efficiency of the layers in the blocking region.

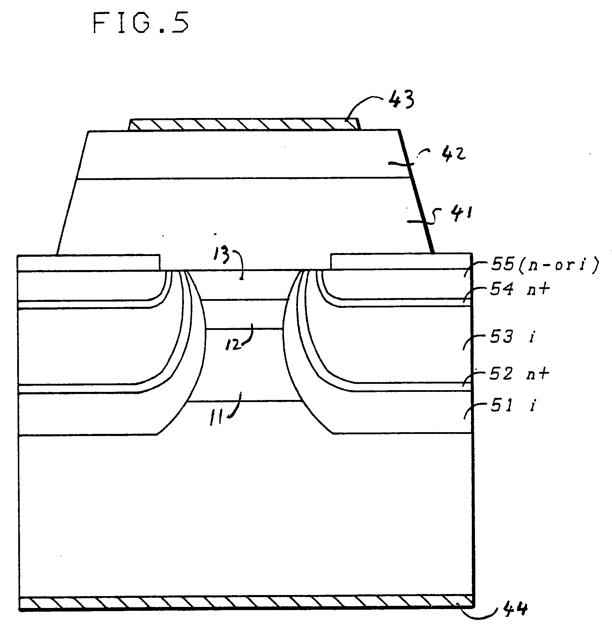

FIG. 5 shows a laser structure similar to that shown in FIG. 4 except with respect to the blocking region. For the structure in FIG. 5, high resistivity semiconductor layer 51 is grown on an exposed surface of substrate 10 (see FIGs. 1 and 2). Layer 51 is overgrown by the following sequence of layers: heavily doped (n+) semiconductor layer 52, high resistivity semiconductor layer 53, heavily doped (n+) semiconductor layer 54, and high resistivity semiconductor layer 55. The range of thicknesses for each epitaxial layer is as follows: layer 51 is 0.2 to 0.5 $\mu m$; layer 52 is 0.1 to 0.5 $\mu m$; layer 53 is 0.1 to 0.5 $\mu m$; and layer 54 is 0.1 to 0.5 $\mu m$.

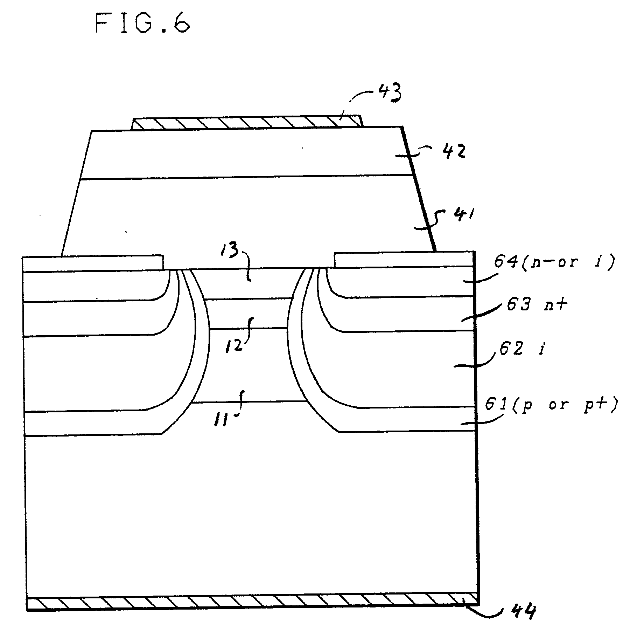

In FIG. 6, a laser structure is shown having a modified blocking region. A thin p-doped semiconductor layer 61 is grown over the n-doped substrate 10 to a thickness of approximately 2000 Angstroms. High resistivity semiconductor layer 62 is grown over layer 61. Heavily doped (n+) semiconductor layer 63 is grown over layer 62. This is followed by the growth of high resistivity semiconductor layer 64. It is understood that the vertical portion of p-doped layer 61 adjacent the buried heterostructure is sufficiently thin to be highly resistive. Except for the addition of layer 61, the blocking region structure in FIG. 6 is identical to that shown in FIG. 4.

Although high resistivity layers 31 and 51 are formed directly on substrate 10, the high resistivity layers may be formed on an undoped or n-doped epitaxial buffer layer (not shown) grown directly on the substrate. In either case, it has been found that the high resistivity is best achieved by metal organic chemical vapor deposition.

It is important to note that the optional epitaxial buffer layer described immediately above, if selected from the proper combination of materials, can serve a dual role in acting as a stop-etch layer during heterostructure mesa formation and as an additional current confining layer in the blocking region by preventing injection leakage currents. In the example described herein, a ternary or quaternary composition from the InGaAsP/InP system such as InGaAs or InGaAsP is grown to a thickness of 100 to 300 Angstroms over the substrate during heterostructure growth as shown in FIG. 1. The epitaxial buffer layer is undoped or n-doped and is impervious to the etchant applied during mesa formation for precisely controlling the depth of the etching process or alternatively the height of the mesa. Moreover, by selecting a material having a narrower energy bandgap than that of the overgrown high resistivity layers, it is possible to enhance the current confining effectiveness of the blocking region.

While the invention has been described with reference to laser devices, it will be appreciated by those skilled in the art that it is applicable to other semiconductor devices such as LEDs, photodiodes, FETs and the like in which substantial current is prevented from flowing through a region of the device.

In addition, the invention is not limited to the InGaAsP/InP system. It will be appreciated by those skilled in the art that the invention may be fabricated in that other semiconductor systems including other Group III-V systems such as AlGaAs/GaAs system.

Finally, it will be further appreciated by those skilled in the art that the conductivity type of device layers may be reversed.

For example, p-doped substrate device structures may be employed.

## Claims

1. A semiconductor device comprising a first region (11,12,13) for conducting current, means (41,42,43,44) for applying said current to at least a portion of said first region, said first region including a major surface, and a second region (31,32,33) in contact with said major surface for substantially restricting said current to said first region, CHARACTERIZED IN THAT said second region comprises a succession of epitaxial layers including a first layer (31) of a first, substantially high resistivity, semiconductor materials, a second layer (32) in contact with said first layer, said second layer being of semiconductor material having a predetermined conductivity type, and a third layer (33) of a second, substantially high resistivity, semiconductor material in contact with said second layer.

2. The semiconductor device as defined in claim 1 wherein said first substantially high resistivity, semiconductor material includes dopant material for causing said first layer to be semi-insulating.

3. The semiconductor device as defined in claim 2 wherein said second substantially high resistivity semiconductor material includes dopant material for causing said third layer to be semi-insulating.

4. The semiconductor device as defined in any of the preceding claims wherein said succession of epitaxial layers further includes a fourth layer (54) of semiconductor material having said predetermined conductivity type, said fourth layer being in contact with said third layer (53).

5. The semiconductor device as defined in any of the preceding claims wherein said succession of epitaxial layers further includes a buffer layer of semiconductor material being substantially undoped or having said predetermined conductivity type, said first layer being positioned between and in contact with said second layer and said buffer layer, and said buffer layer having a narrower energy bandgap than said first layer.

# FIG.1

FIG.2

21

13
12

11 n+

10 n+

FIG.3

34 n+

13

33 (n-ori)

32 n+

12

31 i

11

FIG.4

# FIG.5

43

42

41

55 (n - ori)

54 n+

53 i

52 n+

51 i

13

12

11

44

FIG.6